# EUROPEAN PATENT SPECIFICATION

(11) **EP 0 601 513 B1**
(45) Date of publication and mention of the grant of the patent: **27.09.2000**
(21) Application number: 93119619.0
(22) Date of filing: 06.12.1993
(51) Int. Cl.: H01L 21/203, C23C 14/34, C30B 23/02

(54) **Method for forming deposited epitaxial Si film by sputtering**
Verfahren zur Herstellung einer abgeschiedenen epitaxialen Si-Schicht mittels Zerstäubung
Procédé de fabrication d'un film épitaxial déposé du silicium par pulvérisation

(30) Priority: 07.12.1992 JP 32690292
(43) Date of publication of application: 15.06.1994
(73) Proprietor: CANON KABUSHIKI KAISHA, Tokyo (JP)
(72) Inventor: Ichikawa, Takeshi, c/o Canon Kabushiki Kaisha, Tokyo 146 (JP)
(74) Representative: Bühling, Gerhard, Dipl.-Chem.

(56) References cited:
- EP-A- 0 458 991
- APPLIED PHYSICS LETTERS, vol. 59, no. 3, 15 July 1991, pages 330-332, XP000233821 FENG G F ET AL: "SILICON EPITAXY AT 230 C BY REACTIVE DC MAGNETRON SPUTTERING AND ITS IN SITU ELLIPSOMETRY MONITORING"

## Description

### BACKGROUND OF THE INVENTION

### Field of the invention

This invention relates to a method for forming a deposited film used in fabrication of semiconductor devices, that forms a deposited film such as an epitaxial film by sputtering.

### Related Background Art

Semiconductor devices used in integrated circuits are generally comprised of a thin-film multi-layered product formed by depositing a number of thin films layer by layer, and the quality of each thin film and the state of interfaces between thin films have a great influence on the performance of devices. Hence, high-level thin-film forming and multilayer forming techniques are indispensable for providing high-performance semiconductor devices. In particular, what is called the epitaxial growth technique, which forms an additional high-quality crystal on a crystal face, is a thin-film forming technique indispensable for existing semiconductor techniques, and a number of research and development are being made thereon as techniques greatly influencing device performance without regard to homoepitaxial growth or heteroepitaxial growth. A thin film obtained by epitaxial growth is called an epitaxial film.

In conventional epitaxial growth techniques, CVD processes have been prevalent. However, film formation by CVD is, in general, carried out by a high-temperature process. For example, a film formation process for a silicon film (Si film) is carried out at a high temperature of 1,000°C or above. This has brought about problems such as limitation on processes and a high production cost, ascribable to the high temperature. Moreover, it has now become difficult to meet a demand for making dopant profiles shallower or sharper, which is a recent demand attributable to devices having been more highly integrated and having been made to have a higher performance.

Accordingly, as processes that can meet such demands, processes for low-temperature epitaxial growth are recently reported, including MBE (molecular beam epitaxy; A. Ishikawa and Y. Shiraishi, J. Electrochem. Soc., 133, 666, 1986), as well as FOCVD that carries out film formation by mixing a gaseous material and a halogen type oxidizing agent to cause chemical reaction so that a precursor serving as a feeding source of a film forming material is formed (U.S. Patent No. 4,800,173), HRCVD that carries out film formation by separately introducing into a film forming space, gaseous materials activated in different activation spaces (U.S. Patent No. 4,835,005), PIVD (partly ionized vapor deposition) that utilizes an ion beam process (T. Itoh, T. Nakamura, M. Muromachi and T. Sugiyama, Jpn. J. Appl. Phys. 16553, 1977), IBE (ion beam epitaxy; P.C. Zalm and J. Beckers, Appl. Phys. Lett. 41, 167, 1982), and ICBD (ion cluster beam deposition; I. Yamada, F.W. Saris, T. Takagi, K. Matsubara, H. Takaoka and S. Ishiyama, Jpn. J. Appl. Phys. 19, L181, 1980).

However, the MBE has the problems that it requires a 800°C or higher temperature process to form a high-quality epitaxial thin film and high-density doping can be carried out with difficulty. The FOCVD and HRCVD, which utilize chemical reaction, have the problem that by-products may be formed to cause incorporation of unauthorized impurities into films. In what is called the ion beam process such as IBE or ICBD, the ions used have so large energy that substrates may be damaged, and no high-quality thin films usable in semiconductor devices have been obtained under exisiting circumstances.

The present inventors have reported Si epitaxial growth carried out by RF-DC combined bias sputtering, that has employed a method in which the surface layer is activated while controlling any damage on the substrate by precise control of ion energy (T. Ohmi, T. Ichikawa, et al., J. Appl. Phys. Vol.66, p.4756, 1989).

Hitherto, sputtering has been considered hardly utilizable for the formation of epitaxial films because of its difficulty in the controlling of the damage of substrates due to ion energy. It, however, has many other advantages, i.e.;
(1) it can readily form a large area film;
(2) it can achieve a relatively simple device construction;
(3) it can match usual semiconductor processes; and
(4) it allows easy control of reaction systems.
The foregoing RF-DC combined bias sputtering can keep the advantages of sputtering in the epitaxial film forming techniques.

The RF-DC combined bias sputtering having such advantages, however, has been involved in the following problems.
(1) When processing gas, ie, argon, atoms are incorporated into an epitaxial film in a concentration of 8 × 10¹⁸ cm⁻³ or more, the resulting film may have a low poor quality, and the quality may become extremely poor in a device fabrication process carried out at temperatures higher than film formation temperatures.
(2) The carbon can not be completely prevented from being included in films, and the same problem as in paragraph (1) may arise when carbon is included in a concentration of 1 × 10¹⁸ cm⁻³ or more.
(3) The process has a poor step coverage.
(4) An epitaxial film formed on the (111) crystal face of an Si substrate or a heteroepitaxial film such as an SiGe film formed on an Si substrate may have defects therein chiefly caused by many film deposition defects, to make the state of their interface unsatisfactory.

EP-A-0 458 991 discloses a sputtering method wherein a DC voltage and a plasma-generating high-frequency power are applied to a target. By adjusting the partial pressures of H₂O, CO and CO₂ in an atmosphere of a film-forming space at or below 1.0 x 10⁻⁸ Torr 1 Torr = 133 Pa, and maintaining the substrate at a temperature in a range of from 400 to 700°C during the formation of the epitaxial film, the epitaxial film can be provided.

Applied Physics Letters, Vol. 59, No. 3, 15 July 1991, pages 330 - 332 reports on silicon epitaxy at 230°C by reactive DC magnetron sputtering whereby the partial pressure of hydrogen is adjusted at the applied low temperature of 230°C. However, further improvements of film quality are desired.

### SUMMARY OF THE INVENTION

The present inventors made extensive studies on the cause of the above problems to have reached the following findings.
(1) Argon atoms deposit on a substrate at a large coefficient when the substrate has a low temperature of about 300°C.
(2) The energy possessed by atoms such as Si that undergo epitaxial growth is so small that their surface migration may become insufficient.
(3) Carbon atoms are in the state they tend to be attached to the activated substrate surface.

The present invention was made from such findings.

An object of the present invention is to improve a method for forming a deposited film carried out by the above RF-DC combined bias sputtering, and provide a method for forming a deposited film that can achieve a good step coverage, may cause less film deposition defects to give a good interfacial state, in homoepitaxial growth or heteroepitaxial growth.

Another object of the present invention is to provide a method for forming a deposited film that can provide high-quality crystalline thin films having a small content of argon atoms, carbon atoms and so forth that may impair the quality of thin films, contained in processing gas.

The present invention provides a method for forming a deposited film by a bias sputtering process as defined in claim 1.

Preferred embodiments are defined in the dependent claims.

### BRIEF DESCRIPTION OF THE DRAWINGS

Fig. 1 is a diagrammatic illustration of a bifrequency excitation type bias sputtering apparatus employed for the working of the method of the present invention.
Figs. 2A to 2C are a flow chart to illustrate a process for producing a substrate when the method of the present invention is carried out.
Fig. 3 is a graph to show the relationship between plasma potential and a hydrogen gas content in an embodiment of the present invention.
Fig. 4 is a graph to show the relationship between carbon atom concentration in an epitaxial film and hydrogen gas content in a processing gas, in an embodiment of the present invention.
Fig. 5 is a graph to show the relationship between reverse-current density at p-n junctions and hydrogen gas content in an embodiment of the present invention.
Fig. 6 illustrates an example of the constitution of a base region in a BPT (bipolar transistor).
Fig. 7 illustrates an example of the constitution of an emitter region in the BPT.
Fig. 8 is a graph to show the dependence of film formation rate on target bias in the bias sputtering.

### BRIEF DESCRIPTION OF THE PREFERRED EMBODIMENTS

The method for forming a Si deposited film of the present invention is characterized by a method for forming a Si deposited film by a bias sputtering process comprising the steps of generating plasma between a target electrode holding a Si target material provided in a vacuum container and a substate electrode holding a substrate for forming a Si deposited film, provided opposingly to the target electrode, by the use of a high-frequency energy to cause the Si target material to undergo sputtering, and applying a bias voltage to at least one of the target electrode and the substate electrode to form a Si deposited film comprised of Si atoms having deposited by sputtering on the substrate; wherein a mixed-gas environment comprising a mixture of an inert gas and a hydrogen gas is formed in the vacuum container, and the target material is subjected to sputtering while controlling H₂O gas, CO gas and CO₂ gas in the mixed-gas environment to have a partial pressure of 1.0 × 10⁻⁸ Torr or less each, to form an epitaxial film on the substrate while maintaining a substrate temperature in the range of from 400°C to 700°C.

The present invention may also embrace an embodiment in which the substrate is irradiated with plasma ions before the film formation to clean the surface of the substrate.

The present invention may also embrace an embodiment in which a high-frequency power applied to the substrate has a frequency higher than the frequency of a high-frequency power applied to the target.

According to the present invention constituted as described above, H₂O gas, CO gas and CO₂ gas in a vacuum chamber of a bias sputtering apparatus are each made to have a partial pressure of 1.0 × 10⁻⁸ Torr or less, the substate temperature is maintained at 400 to 700°C, and the epitaxial growth by sputtering is carried out in a mixed-gas environment comprised of an inert gas and a hydrogen gas. Thus, the following advantages can be expected.
(1) The coefficient at which inert atoms such as argon atoms and helium atoms that are the atoms constituting the plasma and not the Si atoms constituting the deposited film deposit on the substrate greatly decreases. As for hydrogen atoms that are the atoms constituting the plasma and not the Si atoms constituting the deposited film, their force to combine with the Si atoms constituting the substrate greatly decreases when the substrate temperature is 400°C or above. Hence, any inclusion of inert atoms and hydrogen atoms, other than deposited film constituent Si atoms, into the deposited film can be greatly decreased.
(2) The quantity of the carbon atoms having a great influence on the device performance even when incorporated into the deposited film in a small quantity can be greatly decreased on account of the reaction with hydrogen gas.

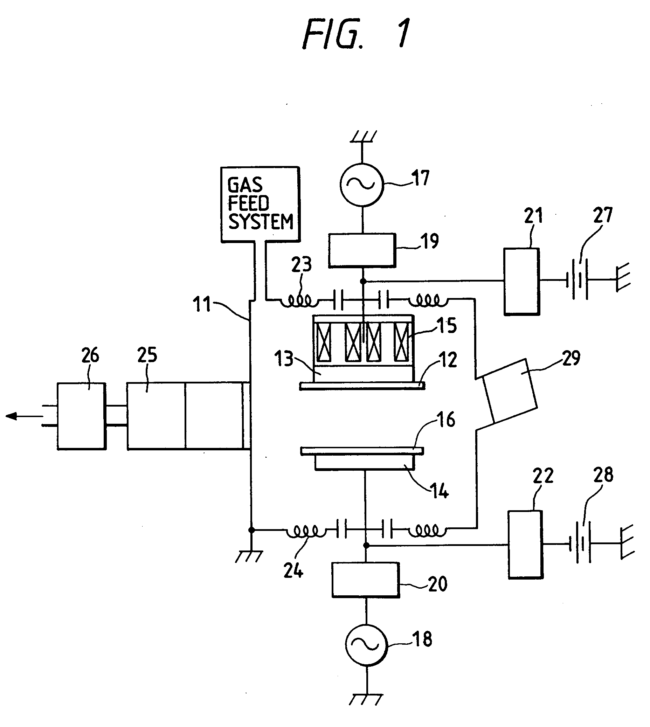

Fig. 1 illustrates a bifrequency excitation type bias sputtering apparatus employed for the working of the method of the present invention. In the drawing, reference numeral 11 denotes a vacuum chamber; 12, a target; 13, a target supporting member; 14, a substrate supporting member; 15, a permanent magnet; 16, a substrate; 17, a 100 MHz high-frequency power source; 18, a 190 MHz high-frequency power source; 19 and 20, matching circuits; 21, a low-pass filter for the target; 22, a low-pass filter for the substrate; 23 and 24, band pass filters; 25, a magnetic levitation type tandem turbo molecular pump; 26, a dry pump; 27, a DC power source for determining the DC potential of the target; 28 a DC power source for determining the DC potential of the substrate; and 29, a xenon lamp for heating the substrate.

The vacuum chamber 11 is made of a material that may cause less gas escape. For example, SUS316 is used as a structural material, and the inner surface of the chamber is surface-treated in the following way: The surface is subjected to combined electrolytic polishing and electrolytic polishing and thereafter mirror-finished to a smoothness of maximum height roughness Rmax < 0.1 µm, on the surface of which a passive oxide film is further formed by the use of high-purity oxygen. The material is by no means limited to the high-purity oxygen so long as any impurity contamination may hardly occur when the substrate temperature is elevated.

A gas exhaust system is comprised of the tandem type turbo molecular pump 25 comprising magnetic levitation type turbo molecular pumps arranged in tandem and the dry pump 26 serving as an auxiliary pump. This exhaust system is an oil-free system that may cause only a very little impurity contamination. The second-stage turbo molecular pump is a pump of a large flow rate type, and can maintain exhaust velocity even at a degree of vacuum on the order of 10⁻³ Torr during plasma generation. The gas exhaust system, including a mass flow controller and filters, is set up using SUS316 as in the case of the vacuum chamber and its inner surface is also subjected to surface treatment by polishing and formation of a passive oxide film so that any unauthorized impurities can be prevented from entering as far as possible when processing gases are fed into it.

The substrate 16 is guided into the vacuum chamber 11 through a load lock chamber (not shown) provided adjoiningly to the vacuum chamber, and thus the unauthorized impurities are prevented from entering in the vacuum chamber.

As a gas feed system, an ultraclean gas feed system and/or an oil-free ultrahigh-vacuum extraction system is/are employed so that the plasma constituent atoms other than the film constituent atoms can be prevented from being included in the film during the formation of epitaxial films.

A high-frequency energy may preferably be applied to the substrate in order to form a more stable plasma. Especially when the substrate is comprised of an insulating material, the frequency of high-frequency energy may be adjusted, so that the potential of the substrate surface can be adjusted. The high-frequency energy applied to the substrate may preferably have a frequency higher than that of the high-frequency energy applied to the target.

As the processing gas to generate plasma, a high-purity gas comprising hydrogen gas mixed with a single material inert gas such as argon or helium or a mixed gas of several kinds of these inert gases. Here, the H₂O gas, CO gas and CO₂ gas contained in the processing gas may each preferably be in a content of 1 ppm or less, and more preferably 100 ppb or less.

The pressure inside the vacuum chamber in the course of the film formation may be kept within the range where discharge takes place. In particular, it may preferably be within the range of from 1 to 50 mTorr.

The substrate may preferably have a surface laid bare cleanly. For example, the substrate provided in the vacuum chamber may be subjected to surface cleaning by irradiation with ions while controlling high-frequency power, DC voltage, gas pressure and so forth so that its surface may have no damage due to irradiation with ions. Here, for the same reasons as in the film formation, the substrate temperature should be in the range of from 400 to 700°C, and the cleaning gas should have a high purity, comprising hydrogen gas mixed with a single material inert gas such as argon or helium or a mixed gas of two or more kinds of inert gases. H₂O gas, CO gas and CO₂ gas should each preferably be made to have a partial pressure of 1.0 × 10⁻⁸ Torr or less.

In the film formation, the gas pressure inside the chamber, the high-frequency power supplied to the Si target, the DC voltage applied to the Si target and the high-frequency power optionally applied to the substrate may preferably be controlled so that the energy possessed by one ion made incident on the substrate can be controlled within the range that may cause no damage on the substrate. When, the substrate is formed of Si and the plasma is for example mainly comprised of argon, the energy possessed by one argon ion should be controlled to be 40 eV or less. The value 40 eV corresponds to the threshold value at which the sputtering of Si is caused by argon, and is an upper limit of ion irradiation energy that may cause no damage on the substrate surface comprising Si.

As a substrate heating means, a lamp irradiation means such as a xenon lamp or a halogen lamp that may cause less impurities or a resistance heating means should be used.

In the method of the present invention, a Si monocrystalline film from the Si target is eptaxially grown in accordance with the information obtained on crystal orientation of the monocrystalline substrate used as a base. At this time, the dopant in the target is incorporated into the film formed, in the proportion as it is contained in the target. When a Si film is formed using a Si target containing the dopant in a given proportion, the resistivity as properties of the resulting film can be optimized to an extent substantially equal to that of Si of the bulk. Especially when the substrate temperature is within the range of from 500 to 600°C, the resistivity of the film formed is 100 to 110% of that of Si of the bulk, showing very good properties. A film formed at substrate temperatures ranging from 500 to 550°C has the smallest resistivity. This fact shows that almost all the dopant in the film has been activated.

According to the method of the present invention, carbon atoms included into the film can be greatly decreased on account of their chemical reaction with hydrogen, so that high-quality epitaxial films can be formed. According to the method of the present invention, the substrate temperature is kept not lower than 400°C, and hence the hydrogen having the function of removing unauthorized impurities can be very easily prevented from being included into the Si epitaxial film. If the substrate temperature is lower than 400°C, the incorporation of hydrogen into the film may increase to bring about a great deterioration of film quality. If on the other hand the substrate temperature is higher than 700°C, the partial pressure of CO and CO₂ around H₂O may increase to bring about a deterioration of film quality and also to make it impossible to meet the demand for making dopant profiles sharper or shallower.

### EXAMPLES

The present invention will be described in greater detail by giving Examples. The present invention is by no means limited by these.

### Example 1

Using the bifrequency excitation type bias sputtering apparatus shown in Fig. 1, epitaxial films were formed on Si (100) just-oriented substrates in the following way. As the target, p-type FZ 120 mm diameter Si doped with boron to have a resistivity of 0.014 Ω ·cm was used.

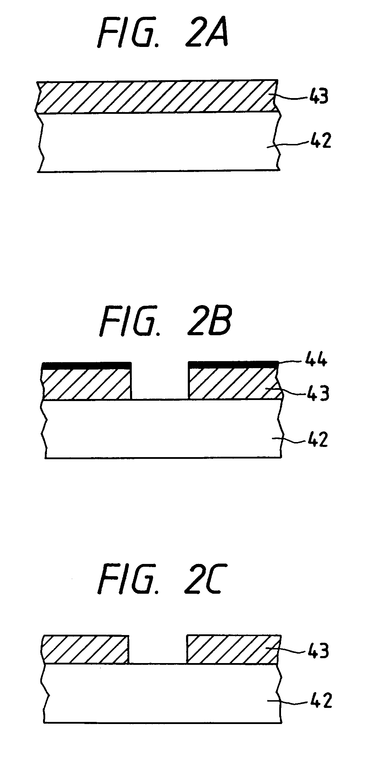

First, as shown in Fig. 2A, thermal oxidation was carried out on the Si substrate 42 at 1,000°C for 54 minutes by resistance heating in an environment comprising H₂ gas and O₂ gas fed at a flow rate of 2 l/min and 4 l/min, respectively, to form an SiO₂ film 43 with a thickness of about 200 nm. From the upper part of this SiO₂ film 43, a resist 44 was spin-coated, followed by known exposure and development. Thereafter, the resulting substrate was moved to a parallel flat type RIE (reactive ion etching) apparatus, and ion etching was carried out under the following conditions to remove the SiO₂ film so that a pattern was formed on the Si substrate as shown in Fig. 2B. This pattern was comprised of a plurality of valleys of 1 µm wide and 1 µm deep and a plurality of squares of 10 µm × 10 µm to 1 mm × 1 mm in size as a plannar shape viewed from the upper part.

**Table 1**

| RIE conditions | | |
|---|---|---|
| Gas flow rate: | CHF₃, 30 sccm | O₂, 5 sccm |
| RF powder: | 700 W | |
| Pressure: | 0.13 Torr | |
| Time: | 3 minutes | |

From the substrate having been subjected to patterning in this way, the resist was separated to obtain the substrate as shown in Fig. 2C.

Next, this substrate was cleaned by a known wet process, and then set on an electrostatic chuck serving as the substrate holding member 14 provided in the chamber 11 of the bias sputtering apparatus shown in Fig. 1, followed by heating to have a substrate temperature of 550°C. Subsequently, argon gas and hydrogen gas were fed in a given proportion from a gas feed system comprising an ultragas feed clean system, and the pressure inside the vacuum chamber was adjusted to 15 mTorr. DC voltage on the side of the substrate 16 and DC voltage on the side of the target 12 were set at prescribed values as shown below and a high-frequency power was supplied to the chamber 11 to thereby carry out ion irradiation surface cleaning by the action of plasma to remove molecules adsorbed on the substrate surface. Next, the DC voltage on the side of the substrate 16, the DC voltage on the side of the target 12 and the high-frequency power were immediately set at prescribed values as shown below, and an Si epitaxial film with a thickness of about 100 nm was formed at a substrate temperature of 550°C. Cleaning of the substrate and the film formation were carried out under conditions also shown below, provided that the frequency of the high-frequency power supplied from the target side was kept constant at 100 MHz.

### - Substrate surface cleaning conditions -

Target side high-frequency power: 5 W
Target side DC voltage: -5 V
Ar gas pressure: 15 mTorr
H₂ gas/(Ar+H₂) gas volume ratio: 20%
Substrate side DC voltage: 10 V
Substrate temperature: 550°C
Processing time: 5 minutes

### - Si epitaxial film forming conditions -

Target side high-frequency power: 100 W
Target side DC voltage: -150 V
Ar gas pressure: 15 mTorr
H₂ gas/(Ar+H₂) gas volume ratio: 0 to 50%
Substrate side DC voltage: 10 V
Substrate temperature: 550°C
Processing time: 5 minutes

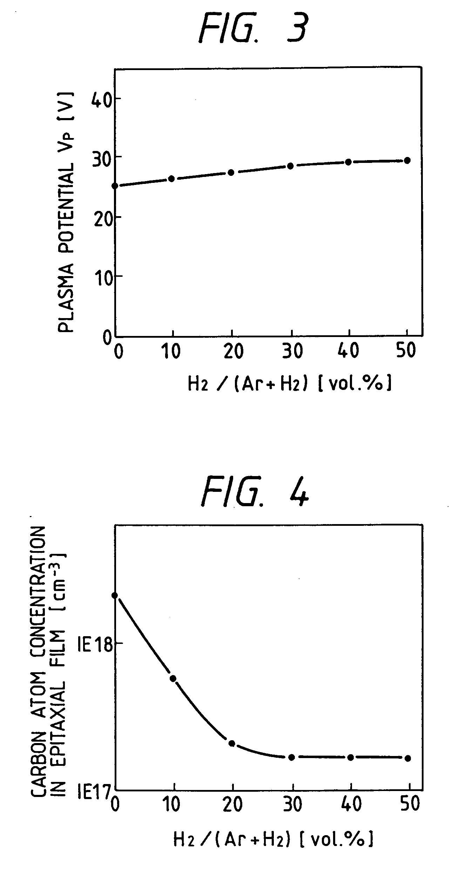

Plasma potential (hereinafter "Vp") at the time of the surface cleaning and at the time of the Si film formation was measured by a conventional Langmuir probe method to obtain the results as shown in Fig. 3. In the drawing, the Vp is indicated as ordinate and the hydrogen gas content in the mixed gas of argon gas and hydrogen gas is indicated as abscissa in volume ratio. In the present Example, the Vp increased with an increase in the content of hydrogen gas in the mixed gas. At this time, substrate potential (hereinafter "Vs") is fixed and kept constant by the DC power source on the substrate side. The ion irradiation energy of the ions made incident on the substrate surface is equal to the potential difference between the Vp and the substrate potential Vs, and hence, when the Vp varies, the ion irradiation energy can be controlled by changing the substrate potential Vs. Thus, the substrate potential Vs was also changed as the plasma potential Vp varied.

With regard to thin films formed on substrates in the manner as described above;
(1) crystal analysis was carried out by electron ray diffraction;
(2) content of impurity atoms of argon, carbon and hydrogen each was measured by SIMS (secondary ion mass spectroscopy);
(3) reverse-current density at p-n junctions at the patterned portions was measured; and
(4) step coverage was evaluated by SEM (scanning electron microscopy) observation.

As a result of the electron ray diffraction, it was ascertained that all the thin films were epitaxially grown without any particularly great difference.

Concentration of carbon atoms incorporated into the film was graphically represented, as shown in Fig. 4. In the drawing, carbon atom concentration in the epitaxial film was indicated as ordinate, and the hydrogen gas content in the mixed gas of argon gas and hydrogen gas is indicated as abscissa in volume ratio. As shown in Fig. 4, the carbon atom concentration in the film decreases with an increase in the content of hydrogen gas in the mixed gas, and it can be ascertained that the hydrogen gas is effective for preventing inclusion of carbon atoms.

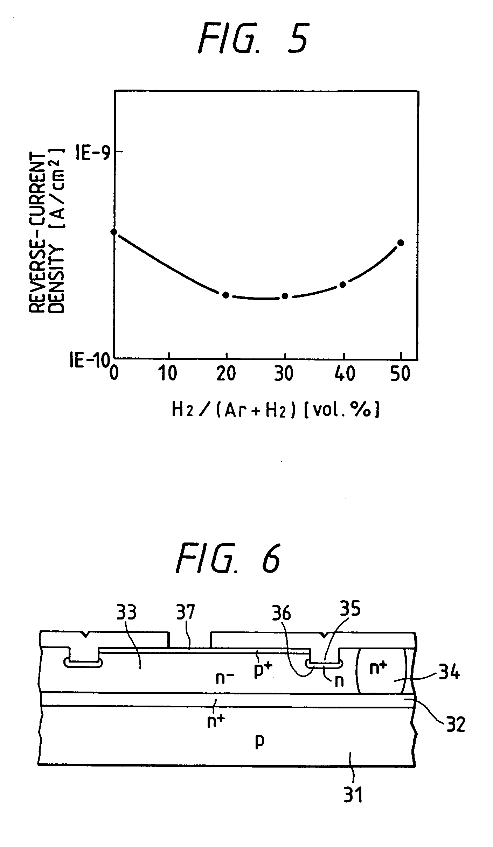

Fig. 5 shows the relationship between the reverse-current density at p-n junctions and the hydrogen gas content. In the drawing, the reverse-current density is indicated as ordinate, and the hydrogen gas content in the mixed gas of argon gas and hydrogen gas is indicated as abscissa in volume ratio. As shown in Fig. 5, in the present Example, a minimum value is seen in the vicinity of 30 vol.% for the hydrogen gas content. This is considered due to the fact that recombination currents have been suppressed because the carbon concentration in the film decreases so far as the hydrogen content is 30 vol.%

As for the step coverage, no great difference ascribable to hydrogen gas was seen.

### Example 2

Next, epitaxial films were formed in the same manner as in Example 1 except that the H₂/(Ar+H2) ratio was fixed at 20%, while changing the substrate temperature in the range of from 300°C to 800°C. Properties of epitaxial films thus obtained are shown in Table 2.

**Table 2**

| Substrate temperature | | | | | | |
|---|---|---|---|---|---|---|
| 300°C | 400°C | 500°C | 550°C | 600°C | 700°C | 800°C |
| | | | | | | |

| Resistivity (Ω·cm): | | | | | | |
|---|---|---|---|---|---|---|
| 1.9×10⁻² C | 1.5×10⁻² A | 1.4×10⁻² A | 1.4×10⁻² A | 1.5×10⁻² A | 1.6×10⁻² A | 9.0×10⁻² D |

| Argon content (cm⁻³): | | | | | | |
|---|---|---|---|---|---|---|
| 8.0×10¹⁸ D | 1.3×10¹⁸ B | 1.0×10¹⁸ B | 8.8×10¹⁷ A | 8.0×10¹⁷ A | 6.0×10¹⁷ A | 8.0×10¹⁸ D* |

| Carbon content (cm⁻³): | | | | | | |
|---|---|---|---|---|---|---|
| 6.0×10¹⁶ A | 8.8×10¹⁶ A | 1.5×10¹⁷ A | 2.1×10¹⁷ B | 3.1×10¹⁷ B | 6.0×10¹⁷ C | 1.4×10¹⁹ D |

| Hydrogen content (cm⁻³): | | | | | | |
|---|---|---|---|---|---|---|
| 1.3×10²⁰ D | 9.4×10¹⁸ B | 1.1×10¹⁸ B | 4.3×10¹⁷ A | 9.7×10¹⁶ A | 9.7×10¹⁶ A | 9.7×10¹⁶ A |

| p-n Junction reverse-current density (A/cm²): | | | | | | |
|---|---|---|---|---|---|---|
| 1.9×10⁻⁹ C | 5.5×10⁻¹⁰ | 2.0×10⁻¹⁰ A | 2.0×10⁻¹⁰ A | 4.0×10⁻¹⁰ A | 6.0×10⁻¹⁰ A | 1.4×10⁻⁸ D |

| Electron ray diffraction: | | | | | | |
|---|---|---|---|---|---|---|
| Streaks B | K-lines A | K-lines A | K-lines A | K-lines A | K-lines A | Streaks C |

| Step coverage: | | | | | | |
|---|---|---|---|---|---|---|
| C | B | A | A | A | A | A |

| Background vacuum degree (Torr): | | | | | | |
|---|---|---|---|---|---|---|
| 2.0×10⁻¹⁰ | 4.0x10⁻¹⁰ | 8.0×10⁻¹⁰ | 3.0×10⁻⁹ | 7.0×10⁻⁹ | 1.0×10⁻⁸ | 8.0×10⁻⁸ |
| K-lines: Kikuchi lines, A: Very good, B: Good, C: Ordinary, D: Poor, -: Unmeasurable | | | | | | |

| | | | | | | |
|---|---|---|---|---|---|---|
| * Crystallizability was a little poor to cause an increase in the content. | | | | | | |

As shown in Table 2, a large quantity of hydrogen atoms remain when the substrate temperature is lower than 400°C. On the other hand, when it is higher than 700°C, the argon content and carbon content increase and also the reverse-current density at p-n junctions increases. The dopant profile began to become a little dull. The argon content is small when the substrate temperature is in the range of from 400°C to 700°C. With regard to the reverse-current density at a p-n junction reverse voltage of 5 V, it is ascertained that minimum values are seen when the substrate temperature is 500 to 550°C and the value abruptly increases the substrate temperature is lower than 400°C or higher than 700°C. The step coverage is greatly improved when it is 400°C or above.

In an instance in which the substrate temperature and the H₂/(Ar+H₂) ratio were set constant at 550°C and 20%, respectively, without any changes in other conditions but the partial pressure of H₂O, CO and CO₂ each was made higher than 1 × 10⁻⁸, electron ray diffracted images became greatly irregular to cause a lowering of crystallizability.

### Example 3

A bipolar transistor (BPT) was fabricated in the following way.

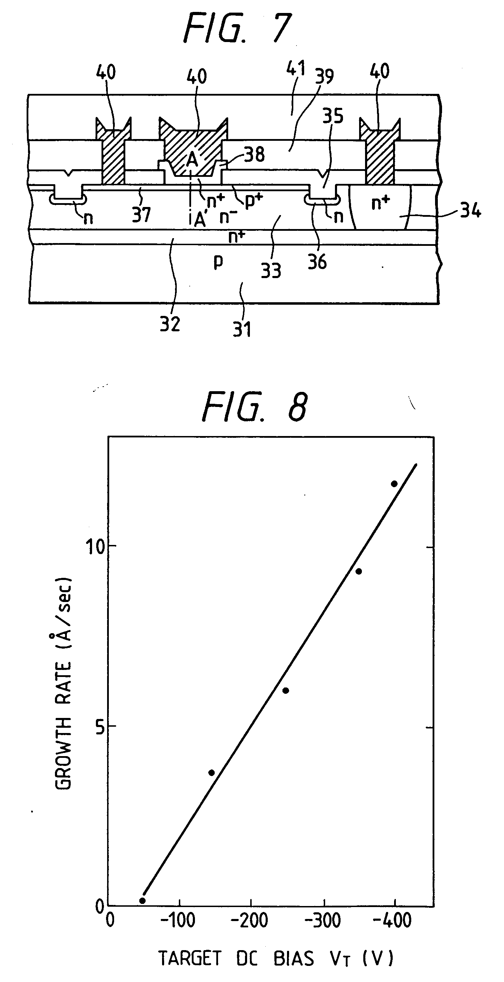

Fig. 6 illustrates an example of the constitution of a base region in the BPT.

On the surface of a p-type Si substrate 31 with a resistivity of 4 Ω·cm, an n⁺-type buried layer 32 was formed by a conventional diffusion process.

On the buried layer 32 thus formed, an n⁻-type region 33 with a layer thickness of 1.2 µm was formed by a conventional epitaxial film forming process.

Subsequently, an n⁺-type region 34 for decreasing the collecter resistance of the BPT was formed in the n⁻-type region 33 by a conventional diffusion process.

Next, in the n⁻-type region 33, As ions were implanted at a dose of 2 × 10¹³ cm⁻² by conventional ion implantation to form a channel stop region 36, followed by normal pressure CVD to form an SiO₂ film, which was then etched according to the RIE etching step previously described, to form a device separating region 35. Reference numeral 37 denotes a p⁺-type base region formed of a film epitaxially grown by bias sputtering.

Next, using the RF-DC combined bias sputtering apparatus as shown in Fig. 1, an about 300 nm thick Si epitaxial film was formed as a base region by the use of a target having a boron concentration of 1.0 × 10¹⁸ cm⁻³. The film was formed under conditions shown below.

### - Substrate surface cleaning conditions -

Target side high-frequency power: 5 W
Target side DC voltage: -5 V
Ar gas pressure: 15 mTorr
H₂ gas/(Ar+H₂) gas volume ratio: 20%
Substrate side DC voltage: 10 V
Substrate temperature: 550°C
Processing time: 5 minutes

### - Si epitaxial film forming conditions -

Target side high-frequency power: 100 W
Target side DC voltage: -150 V
Ar gas pressure: 15 mTorr
H₂ gas/(Ar+H₂) gas volume ratio: 10%
Substrate side DC voltage: 5 V
Substrate temperature: 550°C
Processing time: 15 minutes

The Vp in the course of the Si film formation was 25 eV. The Vs was set at 5 eV. Hence, the argon ions in plasma gained an energy of 20 eV corresponding to the potential difference between them, with which the substrate had been irradiated. This value was a value suited to carry out epitaxial growth without damaging the substrate. Meanwhile, the Vp and Vs in the course of the substrate surface cleaning was 18 eV and 10 eV, respectively, and the argon ion irradiation energy on the substrate surface was 8 eV. Then, a substrate with contact holes made therein for forming an emitter was made ready, and was cleaned by a conventional wet process, followed by RF-DC combined bias sputtering again, to form an about 500 nm thick Si epitaxial film on the substrate. The target was comprised of 1 × 10²¹ cm⁻³ n⁺FZ (100) Si. The film was formed under conditions shown below.

### - Substrate surface cleaning conditions -

Target side high-frequency power: 5 W
Target side DC voltage: -5 V
Ar gas pressure: 15 mTorr
H₂ gas/(Ar+H₂) gas volume ratio: 20%
Substrate side DC voltage: 15 V
Substrate temperature: 550°C
Processing time: 5 minutes

### - Si epitaxial film forming conditions -

Target side high-frequency power: 100 W
Target side DC voltage: -400 V
Ar gas pressure: 15 mTorr
H₂ gas/(Ar+H₂) gas volume ratio: 0%
Substrate side DC voltage: 5 V
Substrate temperature: 550°C
Processing time: 5 minutes

The Vp in the course of the Si film formation decreased to 20 eV since the target potential was set at -400 eV. The Vs was set at 0 eV. Hence, the argon ions in plasma gained an energy of 20 eV corresponding to the potential difference between them, with which the substrate had been irradiated. This value was a value suited to carry out epitaxial growth without damaging the substrate. Meanwhile, the Vp and Vs in the course of the substrate surface cleaning was 18 eV and 10 eV, respectively, and the argon ion irradiation energy on the substrate surface was 8 eV.

The resulting film was subjected to patterning by a conventional process to form an emitter region. Fig. 7 illustrates an example of the constitution of the emitter region in the BPT.

An insulating film 39 comprised of SiO₂ with a layer thickness of 0.5 µm was deposited by conventional normal pressure CVD, and contact holes were formed by patterning, followed by conventional sputtering to superpose TiN and Al-Si-Cu in layers to form wiring electrodes 40.

An insulating film 41 comprised of SiO₂ was deposited, and an external withdrawing outlet was worked by a conventional semiconductor process.

The foregoing schematically illustrates a process for fabricating the BPT. What are most important in the process are the steps of forming the base and the emitter that influence the performance of the BPT. First, in the base region, in order to obtain a high-performance BPT, it is strongly demanded to make base resistance lower, suppress recombination currents in the base and at the base interface, and decrease irregularities thereof. Hence, it is strongly demanded to make the base region shallower, make the dopant profile more uniform, and make the base-collector interface and base-emitter interface clean and flat. The present invention has made it possible to achieve the film quality and interfacial state that can meet such demands. That is, the present invention has made it possible to obtain an epitaxial interface having a low reverse-current density and a sharp dopant profile and also free from unauthorized impurities such as naturally occurring oxide films. The present bias sputtering also enables easy formation of thin films, and is advantageous for making the profile shallower. It has been ascertained that BPTs having base regions of up to 10 nm can be fabricated and operated. Fig. 8 is a graph to show the dependence of film formation rate on target bias in the bias sputtering. Film forming conditions other than target bias are made constant, which are as shown below.

### - Substrate surface cleaning conditions -

Target side high-frequency power: 5 W
Target side DC voltage: -5 V
Ar gas pressure: 15 mTorr
H₂ gas/(Ar+H₂) gas volume ratio: 20%
Substrate side DC voltage: 10 V
Substrate temperature: 550°C
Processing time: 5 minutes

### - Si epitaxial film forming conditions -

Target side high-frequency power: 100 W
Target side DC voltage: -50 to -400 V
Ar gas pressure: 15 mTorr
H₂ gas/(Ar+H₂) gas volume ratio: 10%
Substrate side DC voltage: 5 V
Substrate temperature: 550°C

For example, when the target bias was -50 V, a film of 10 nm thick was obtained in about 10 minutes. Stated additionally, the film showed a good crystallizability.

As for the emitter region, the recombination and irregularities at the emitter-base interface are as described above. With regard to the achievement of a lower emitter resistance, the emitter is comprised of monocrystalline Si while conventional DOPOS (doped poly-Si) emitters are comprised of polycrystalline Si, and hence it has become possible to achieve a lower emitter resistance.

### Example 4

In the present Example, the apparatus in Example 1 previously described was used, and a p-type (1.0 × 10¹⁵ cm⁻³ boron-doped Si (111) FZ wafer made 4°-off in the direction of 〈211〉) was used as the substrate. Substrate surface cleaning and film formation were carried out under conditions shown below.

### - Substrate surface cleaning conditions -

Target side high-frequency power: 5 W
Target side DC voltage: -5 V
Xe gas pressure: 15 mTorr
H₂ gas/(Xe+H₂) gas volume ratio: 20%
Substrate side DC voltage: 9 V
Substrate temperature: 550°C
Processing time: 5 minutes

### - Si epitaxial film forming conditions -

Target side high-frequency power: 200 W
Target side DC voltage: -200 V
Xe gas pressure: 15 mTorr
H₂ gas/(Xe+H₂) gas volume ratio: 20%
Substrate side DC voltage: -7 V
Substrate temperature: 550°C
Processing time: 5 minutes (150 nm)

The Vp in the course of the Si film formation was 22 eV. The Vs was set at -7 eV. Hence, the xenon ions in plasma gained an energy of 29 eV corresponding to the potential difference between them, with which the substrate had been irradiated. This value was a value suited to carry out epitaxial growth without damaging the substrate. Meanwhile, the Vp and Vs in the course of the substrate surface cleaning was 17 eV and 9 eV, respectively, and the xenon ion irradiation energy on the substrate surface was 8 eV.

Optimum values of plasma parameters at the time of Si film formation are different from those in the case of the Si (100) substrate as shown in Example 1 because of, e.g., the difference in surface energy between Si (111) and Si (100). However, with regard to the properties of Si thin films and others, very good films showing substantially the same results were obtained.

### Example 5

In the present Example, the apparatus in Example 1 previously described was used, and an Si (001) monocrystalline film was formed on the (1012) plane of an insulating material, monocrystal sapphire (Al₂O₃) substrate. Since the substrate is an insulating material, the energy of ions with which the substrate is irradiated, influenced by the potential of the substrate surface (i.e., the difference between plasma potential and substrate potential), depends on the high-frequency power supplied to the substrate and the frequency of the high-frequency power. As the target material, an n-type 1.8 × 1018 cm⁻³ phosphorus-doped FZ Si (111) substrate was used, and Si was heteroepitaxially grown. Substrate surface cleaning and film formation were carried out under conditions shown below.

### - Substrate surface cleaning conditions -

Target side high-frequency power: 5 W
Frequency of target side high-frequency power: 100 MHz
Target side DC voltage: -5 V
Substrate side high-frequency power: 10 W
Frequency of substrate side high-frequency power: 190 MHz
Ar gas pressure: 15 mTorr
H₂ gas/(Ar+H₂) gas volume ratio: 20%
Substrate side DC voltage: 5 V
Substrate temperature: 550°C
Processing time: 5 minutes

### - Si epitaxial film forming conditions -

Target side high-frequency power: 200 W
Frequency of target side high-frequency power: 100 MHz
Target side DC voltage: -200 V
He+Ar gas pressure: 15 mTorr
H₂ gas/(He+Ar+H₂) gas volume ratio: 20%
Substrate temperature: 550°C
Processing time: 5 minutes (1,500 nm)

The Vp in the course of the Si film formation was 31 eV. The Vs was set at -1 eV. Hence, the argon ions in plasma gained an energy of 32 eV corresponding to the potential difference between them, with which the substrate had been irradiated. This value was a value suited to carry out epitaxial growth without damaging the substrate. Meanwhile, the Vp and Vs in the course of the substrate surface cleaning was 22 eV and 8 eV, respectively, and the argon ion irradiation energy on the substrate surface was 14 eV.

The thin film thus formed was subjected to light etching, a process carried out to make any crystal defects conspicuous, to observe etch pit density and also subjected to sectional TEM (transmission electron microscopy) to observe defect density such as layer defects or transfer. As a result, both the etch pit density and the defect density were each 1.0 × 10⁷ to 1.0 × 10⁸ pits defects/cm.

In order to examine inclusion of Al into the Si thin film, measurement by SIMS was carried out to reveal that Al concentration in the Si thin film was a measurment limit 2 × 10¹⁵ cm⁻³ or less. Hole mobility of electrons was also measured by hole measurement to reveal that it showed a value of 240 cm²/V·sec at normal temperature of 300 K, which was substantially equal to that of the bulk.

As is clear from the foregoing results, an SOS (sapphire on silicon) thin film was obtained. With regard to also the problem of elastic compression strain occurring in the Si thin film because of a difference in the coefficient of thermal expansion between sapphire and Si (9.5 × 10⁻⁶/°C and 4.2 × 10⁻⁶/°C, respectively), it was 1 × 10⁸ dyne/cm² or less because of the growth temperature as low as 550°C, bringing about a great improvement.

As is clear from what has been described above, the method for forming a Si deposited film of the present invention makes it possible to stably form high-quality Si monocrystalline thin films having a good step coverage and causing less film deposition defects. Since the films can be formed at low temperatures, it is also possible to prevent the dopant in the film from diffusing into unauthorized regions of the film deposited regions and to form a sharp profile.

A method for forming a Si deposited film by a bias sputtering process comprises the steps of generating plasma between a target electrode holding a Si target material provided in a vacuum container and a substate electrode holding a substrate for forming a Si deposited film, provided opposingly to the Si target electrode, by the use of a high-frequency energy to cause the Si target material to undergo sputtering, and applying a bias voltage to at least one of the target electrode and the substate electrode to form a Si deposited film comprised of Si atoms having deposited by sputtering on the substrate, wherein;
a mixed-gas environment comprising a mixture of an inert gas and a hydrogen gas is formed in the vacuum container, and the Si target material is subjected to sputtering while controlling H₂O gas, CO gas and CO₂ gas in the mixed-gas environment to have a partial pressure of 1.0 × 10⁻⁸ Torr or less each, to form a Si epitaxial film on the substrate while maintaining a substrate temperature in the range of from 400°C to 700°C.

## Claims

1. A method for forming a Si deposited film by a bias sputtering process comprising the steps of;
generating plasma between a target electrode holding a Si target material provided in a vacuum container and a substrate electrode holding a substrate for forming a Si deposited film, provided opposingly to the target electrode, by the use of a high-frequency energy to cause the Si target material to undergo sputtering; and
applying a bias voltage to at least one of the target electrode and the substrate electrode to form a Si deposited film comprised of Si atoms having been deposited by sputtering on the substrate, wherein;
the Si target material is subjected to sputtering while controlling H₂O gas, CO gas and CO₂ gas in the mixed-gas environment to have a partial pressure of 1.33 x 10⁻⁶ Pa (1.0 x 10⁻⁸ Torr) or less each, to form a Si epitaxial film on the substrate while maintaining a substrate temperature in the range of from 400°C to 700°C
**characterized in that**
a mixed-gas environment comprising a mixture of an inert gas and a hydrogen gas is formed in the vacuum container.

2. The method according to claim 1, wherein, before the epitaxial film is formed, the substrate is irradiated with ions in the plasma to clean the substrate.

3. The method according to claim 1, wherein a DC voltage is applied to the substrate.

4. The method according to claim 1, wherein a high-frequency voltage is applied to the substrate.

5. The method according to claim 4, wherein the frequency of the high-frequency voltage applied to the substrate is higher than the frequency of the high-frequency voltage applied to the target.

## Patentansprüche

1. Verfahren zur Bildung eines abgeschiedenen Siliziumfilms durch ein Vorspannungssputterverfahren, das folgende Schritte umfasst:
Erzeugung eines Plasmas zwischen einer Targetelektrode, die ein in einen Vakuumbehälter bereitgestelltes Siliziumtargetmaterial, hält und einer Substratelektrode die ein gegenüber der Targetelektrode bereitgestelltes Substrat zur Bildung eines abgeschiedenen Siliziumfilms hält, unter Verwendung einer Hochfrequenz-energie um das Siliziumtargetmaterial zu zerstäuben;
Anlegung einer Vorspannung an wenigstens der Target- oder der Substratelektrode, um einen abgeschiedenen Siliziumfilm auszubilden, der durch Sputtern auf dem Substrat abgelagerte Siliziumatome umfasst, wobei
das Siliziumtargetmaterial zerstäubt wird, während H₂O-, CO- und CO₂-Gas in der Mischgas-Umgebung auf einen Partialdruck von jeweils 1,33x10⁻⁶Pa (1,0x10⁻⁸Torr) oder weniger eingestellt werden, um einen epitaxialen Siliziumfilm auf dem Substrat auszubilden, während die Substrat-temperatur in der Spanne von 400°C bis 700°C gehalten wird.
**dadurch gekennzeichnet, dass**
eine Mischgas-Umgebung, die eine Mischung aus einem inerten Gas und einem Wasserstoffgas umfasst, in dem Vakuumbehälter gebildet wird.

2. Verfahren nach Anspruch 1, wobei bevor der Epitaxialfilm gebildet wird, das Substrat mit Ionen in dem Plasma bestrahlt wird, um das Substrat zu reinigen.

3. Verfahren nach Anspruch 1, wobei eine Gleichspannung an das Substrat angelegt wird.

4. Verfahren nach Anspruch 1, wobei eine Hochfrequenzspannung an das Substrat angelegt wird.

5. Verfahren nach Anspruch 4, wobei die Frequenz der Hochfrequenzspannung die an das Substrat angelegt wird, höher ist als die Frequenz der Hochfrequenzspannung die an das Target angelegt wird.

## Revendications

1. Procédé de formation d'un film déposé de Si au moyen d'un procédé de pulvérisation polarisée, comprenant les étapes consistant à :
générer un plasma entre une électrode à cible portant une matière cible formée de Si disposée dans un conteneur sous vide et une électrode à substrat, portant un substrat pour former un film déposé de Si, disposée à l'opposé de l'électrode à cible, grâce à l'utilisation d'une énergie à haute fréquence pour obliger la matière cible formée de Si à subir une pulvérisation ; et
appliquer une tension de polarisation sur au moins l'une de l'électrode à cible et de l'électrode à substrat pour former un film déposé de Si constitué d'atomes de Si qui ont été déposés sur le substrat par pulvérisation ; dans lequel on soumet la matière cible formée de Si à une pulvérisation tout en maîtrisant le gaz H₂O, le gaz CO et le gaz CO₂ dans l'environnement de gaz mélangés de façon à ce qu'ils aient chacun une pression partielle de 1,33 x 10⁻⁶ Pa (1,0 x 10⁻⁸ torr) ou moins pour former un film épitaxial de Si sur le substrat tout en maintenant le substrat à une température comprise entre 400°C et 700°C, caractérisé en ce qu'un environnement de gaz mélangés comprenant un mélange d'un gaz inerte et de gaz hydrogène est formé dans le conteneur sous vide.

2. Procédé selon la revendication 1, dans lequel, avant de former le film épitaxial, on irradie le substrat avec des ions dans le plasma pour nettoyer le substrat.

3. Procédé selon la revendication 1, dans lequel on applique une tension continue sur le substrat.

4. Procédé selon la revendication 1, dans lequel on applique une tension à haute fréquence sur le substrat.

5. Procédé selon la revendication 4, dans lequel la fréquence de la tension à haute fréquence appliquée sur le substrat est supérieure à la fréquence de la tension à haute fréquence appliquée sur la cible.
